Europäisches Patentamt

(19) European Patent Office

Office européen des brevets

(11) Publication number: **0 042 058**
**A1**

# (12) EUROPEAN PATENT APPLICATION

(21) Application number: **81103369.5**

(22) Date of filing: **05.05.81**

(51) Int. Cl.³: **G 11 C 19/08**

(30) Priority: **16.06.80 US 159706**

(43) Date of publication of application: **23.12.81**
**Bulletin 81/51**

(84) Designated Contracting States: **DE FR GB**

(71) Applicant: **International Business Machines Corporation, Armonk, N.Y. 10504 (US)**

(72) Inventor: **Voegeli, Otto, 13465 Sycamore Avenue, Morgan Hill California 95037 (US)**

(74) Representative: **Chaudhry, Mohammad Saeed, IBM United Kingdom Patent Operations Hursley Park, Winchester Hants, S021 2JN (GB)**

(54) **A domain disjunction memory system.**

(57) This invention relates to a memory system comprising a host domain (12, 14) forming a pattern having substantially zero netmagnetization, said pattern having a plurality of bit locations therein, and at least one disjunction (16) in said pattern at one of said bit locations wherein the presence or absence of a disjunction at each bit location represents a bit of binary information.

1

A DOMAIN DISJUNCTION MEMORY SYSTEM

This invention relates to a domain disjunction memory system.

Bubble domain memory systems require either a current access or a field access propagation scheme. The field accessing propagation mode has been the propagation mode most widely used by the industry for some time. Field accessing propagation modes are described in U.S. patentS 3,534,346, 3,541,534, and 3,797,001. The term "field access" characterizes a method which utilizes patterns of soft magnetic elements which are located on top of the domain layer. The elements are of geometries to exhibit magnetic poles in the presence of a magnetic field in the plane of the domain layer. Moreover, the elements are disposed such that the poles are produced in consecutively offset patterns in response to reorientations of the in-plane field so that the domains are moved from an input to an output position along a channel defined by the elements. With a rotating in-plane field, the asymmetric chevron bar or C-bar magnetically soft element geometries are commonly employed.

A problem with this type of conventional field access devices is that the density of the memory is limited because the minimum resolution of the propagation element geometries or features is about 1/2d, where d is the bubble diameter. Another problem with field access devices is the cost of the drive coil assembly and associated electronics constitutes a large portion of the total memory cost. Since the cost of the rotating drive field system is largely independent of memory capacity, the cost of small capacity memories using the field access approach is expensive. It is yet another problem with conventional field access devices that the use of soft magnetic elements on top of the domain layer provides enhanced coupling between adjacent bubbles through such elements. As device operation requires the bubbles to remain essentially non-interacting, a separation of at least four bubble diameters between adjacent
bubbles is necessary and storage density is limited accordingly.
Another problem with conventional field access devices is that power
and voltage limitations in the drive coils and associated electronics
severely limit the operating frequency of such memories.

Current accessing has been more widely used in the propagation
of bubbles in a bubble lattice. A current access propagation scheme
specifically for bubble lattice translation is described in U.S.
patent 4,023,150. This current access propagation system is a
combination of two arrays of parallel conductors and confining
means. One array of parallel conductors is oriented at an angle of
60° to the lattice translation axis. The other array of conductors
is at an angle of -60° to the lattice translation axis. Positioned
between the rows of bubbles in the lattice are confining means which
define the lattice translation axis. This current axis system
translates the entire bubble lattice in either of two directions
along the translation axis.

A current access propagation scheme specifically for isolated
bubbles is described in U.S. Patent 4,164,028. This current access
bubble memory system includes a device for propagating and switching
isolated bubbles within a plurality of orthogonal propagation channels.
The device includes two orthogonal arrays of parallel current conductors oriented at 45° angles to the two orthogonal bubble translation
axes. The conductors in each array are regularly spaced a distance
S apart from centre to centre. The first array of conductors are
connected in parallel to a first current source and the second array
of conductors are connected in parallel to a second current source.
As the two arrays of conductors need not be insulated, they may be
fabricated from a single conductor sheet. The propagation channels
are defined by confining means to have a width d where d is the
bubble diameter. The centreline of the channels are spaced a
distance of about $\sqrt{2}$ S/8 from the centre of adjacent conductor

3

intersections. Bubble translation occurs through sequential activation of the two bipolar current sources. Use of specific activation sequences allow selective control of the bubble propagation path at channel intersections.

A problem common to all of the bubble domain systems described above is that they all require means to provide a bias field for maintaining the integrity of the bubble domains. The bias field means increases the cost of the system. In addition, conventional bubble memory chips are operable only over a comparatively narrow margin of bias field. With multi-chip bubble modules, bubble material parameters must therefore be controlled so narrow specifications and/or chips must be sorted according to their bias field values. Measuring and sorting of the chips further increases the module cost.

According to the invention there is provided a memory system characterised in that the memory system comprises a host domain forming a pattern having substantially zero net-magnetization, said pattern having a plurality of bit locations therein, and at least one disjunction in said pattern at one of said bit locations wherein the presence or absence of a disjunction at each bit location represents a bit of binary information.

The invention will now be described by way of example with reference to the accompanying drawings, in which:-

FIGURE 1 is a top view of a disjunction in a host magnetic domain;

FIGURE 2 is a cross-sectional view of an etched confinement structure and the resulting internal bias configuration;

FIGURE 3 is a cross-sectional view of a cross hatch conductor section and the drive field configuration with associated bit positions;

FIGURE 4 is a top view of the cross hatch conductor geometry and some disjunction data patterns along three host domains; and

FIGURE 5 is a top view of a field accessed shift register showing the host domain pattern and soft magnetic elements.

A memory system embodying the invention contains a host domain pattern that consists of stripe domains whose configuration is defined by a fabricated confinement structure. All of the stripe domains are separated by a distance substantially equal to their width to provide substantially zero net-magnetization. The host domain pattern has a plurality of bit locations defined by the superpositioned propagation means. At each bit location, the presence or absence of a disjunction represents a bit of binary information. This information may be translated along the host domain pattern by the propagation means. Examples of propagation means are conductor patterns, such as the cross hatch conductor geometry with current accessing, and permalloy patterns with field accessing.

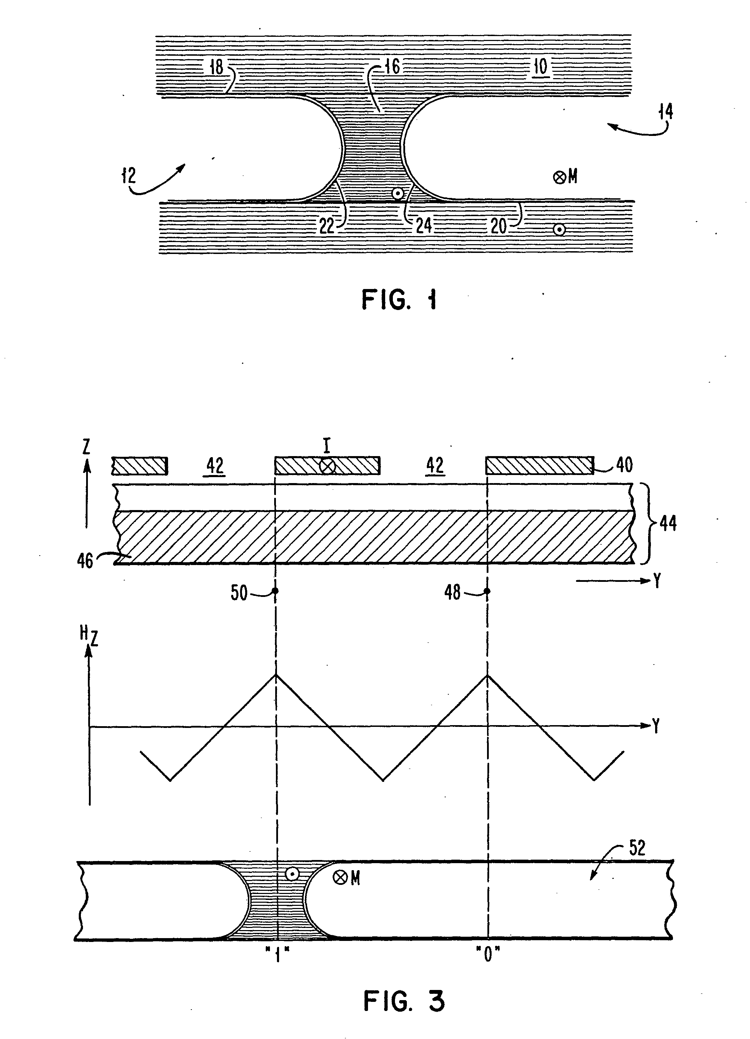

As shown in Figure 1, the magnetic domain memory system 10 has a host domain pattern which consists of stripe domains 12 and 14 that are separated by a disjunction 16. The disjunction thus consists of the two semicircular domain walls 22 and 24 which are the tips of stripe domains 12 and 14 respectively. The stripe domains 12 and 14 form a pattern which is defined by confinement walls 18 and 20.

The host domain pattern consists of stripe domains whose configuration is imposed with a fabricated confinement structure. One proven confinement structure is a reduction in the thickness of the bubble material, either by etching or by an overdose of ion-implantation along the desired stripe locations. An etched confinement structure is shown in Figure 2 where a layer of bubble material 26 has etched regions 28 of reduced thickness. The stripe domains of the host pattern are located in the etched regions 28, having the magnetization pointing down. The device layout is such that all stripes in regions 28 are separated by a confinement stripe domain 30 having its magnetization pointing up and having a width which is equal to the width of the host stripe domain, that is, the width of region 28, in order to provide substantially zero net-magnetization. Only weak confinement is needed when the material parameters of the host domain film are chosen such that its material stripe periodicity at zero bias field is substantially equal to the periodicity of the fabricated confinement structure. The surface topography shown in the upper part of Figure 2 produces a Z field profile, $H_z$, as indicated in the lower portion of Figure 2. The $H_z$ profile, in turn, confines the host domains with their magnetization, M, pointing downward in the field direction and confinement domains with their magnetization, M, pointing upward in the field direction. Since the confinement domains comprise half the area and the host domains comprise half the area, there is zero net-magnetization and thus no requirement for a bias field. It is an important advantage to provide a magnetic domain memory that does not require a bias field.

A stripe domain in region 28 may constitute a propagation channel, that is be a translation domain, or some stripe domains may merely serve to retain a demagnetized domain pattern over the whole of a chip area, that is, be a passive domain. The coding of this magnetic domain memory system consists of the presence or absence of a disjunction at each bit location along the translation domain.

In disjunction propagation, the moving entity is a coupled pair of semicircular domain walls which is similar to bubbles. Many of the conventional bubble manipulation methods, can also be used with disjunctions. Whereas bubbles do not provide a self-contained memory chip because they are unstable without a bias field, the memory system containing a disjunction is self-contained because disjunctions are stable without bias. A cross hatch conductor drive is ideally suited to provide the current access function since the host domains as well as the conductor array have a compatible periodic pattern. Figure 3 illustrates the disjunction translation with a cross hatch current drive. The cross hatch current drive has a conductor 40 with openings 42 therein which are positioned over the host domain located in layer 46 confined by confinement domains in layer 44. Periodic bit positions 48 and 50 along a translation domain 52 are defined by the cross hatch conductor 40 with the openings 42. A disjunction representing a binary "one" is located at bit position 50, while a "zero" is located at bit position 48. The current, I, produces a Z field profile $H_Z$. As current rotates in the conductor plane, the Z field profile translates in the Y direction. The disjunction moves in the $+H_Z$ potential well along the translation domain.

The compatible periodicity of the conductor and the host domain pattern is illustrated in Figure 3. Shown on the top is a cross hatch conductor section 54 containing the conductor 56 with the openings 58 therein. A section of the host domain pattern is visible in the lower part of the drawing. This section includes three translation domains 60, 62 and 64 that are encoded with a 101, 111 and 000 data pattern respectively. The translation direction alternates from channel to channel as shown by the arrows. Interconnecting vertical segments of the translation domain complete a shift register.

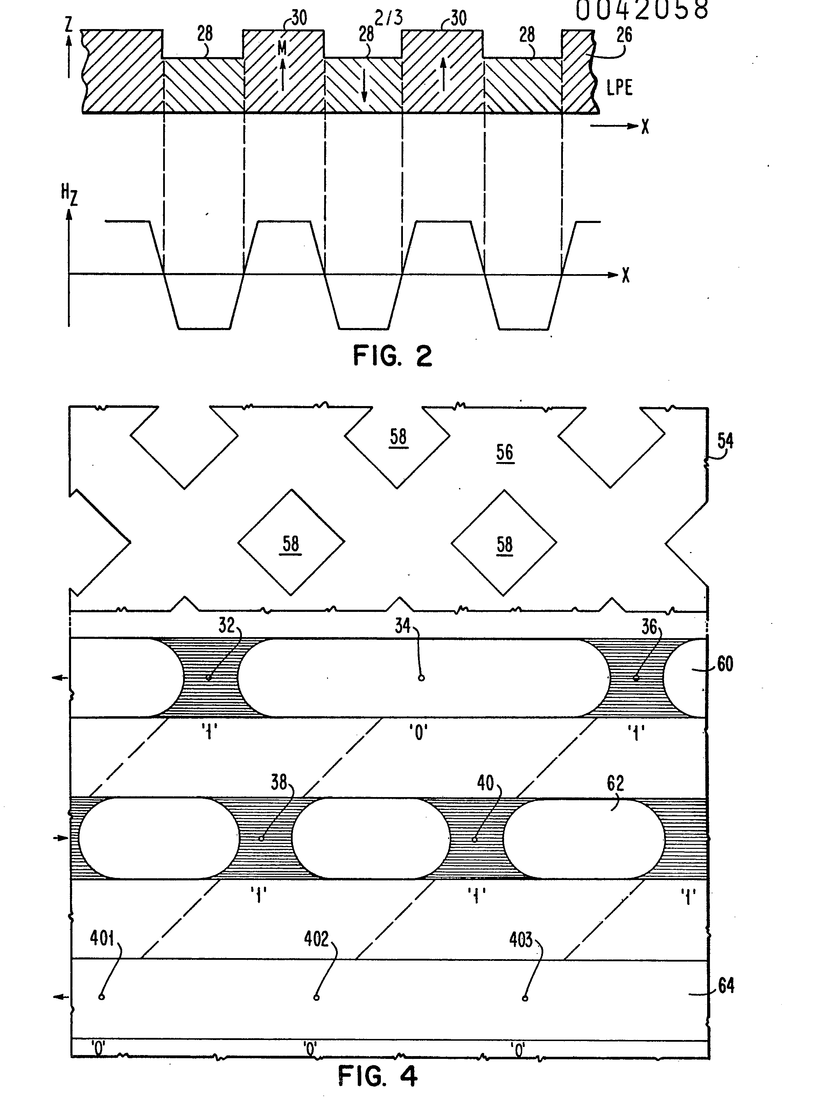

As shown in Figure 4, a disjunction is located at bit positions 32, 36, 38 and 40, whereas there is no disjunction at bit position 34, 401, 402 and 403. Disjunctions are generated with a generation component at the input end of a translation domain. When the generation component raises the Z field across the translation domain to a value $H_Z$ equivalent $\sim 4\pi M_s$, the domain is severed and a disjunction generated. The disjunction thus consists of the two semicircular domain walls comprising the tips of the severed stripe domain. Because of magnetostatic interactions between these tips, the disjunction is a stable magnetic entity whose geometry varies with the local Z field. Like a bubble domain, a disjunction can be generated, translated, expanded and annihilated. A local Z field of about $4\pi M_s$ generates or annihilates the disjunction, depending upon the field polarity, while Z field gradients which are of similar amplitude as for bubble propagation, will move the disjunction along the translation domain.

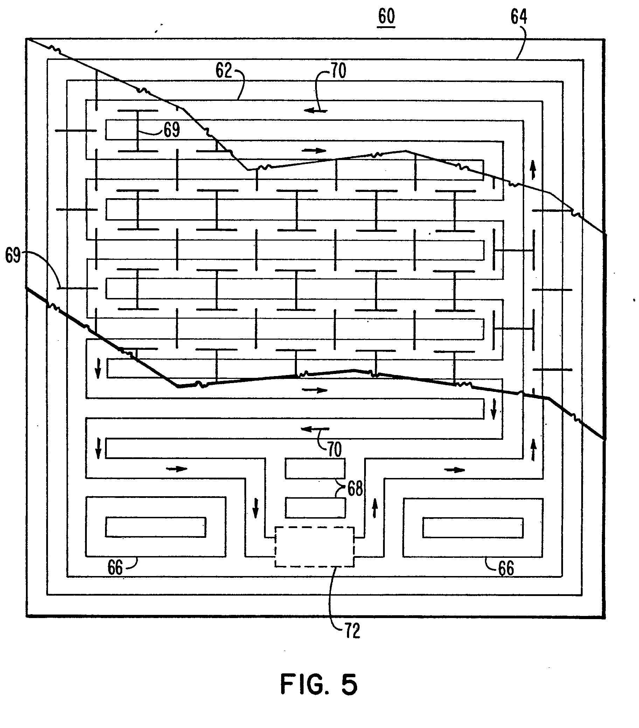

While a preferred embodiment of a domain disjunction device has been described with current accessing, and implementation of this invention is not limited to this cess scheme. Other access schemes include field accessing as is illustrated in Fig. 5. This figure shows a chip of bubble material with a host domain pattern 60. The host domain pattern 60 contains a contiguous translation domain 62 and passive domains 64, 66 and 68 whose purpose it is to retain a demagnetized state of magnetization across the whole chip area. A suitable pattern of soft magnetic propagation elements 69 is shown over some segment of the chip area. This pattern provides for disjunction translation along the contiguous translation domain 62 in the directions indicated by arrows 70 for a counterclockwise sense of the rotation of the drive field. The translation domain forms a closed loop through the read/write means 72.

0042058

8

CLAIMS

1. A memory system characterised in that the memory system comprises a host domain (12, 14) forming a pattern having substantially zero net-magnetization, said pattern having a plurality of bit locations therein, and at least one disjunction (16) in said pattern at one of said bit locations wherein the presence or absence of a disjunction at each bit location represents a bit of binary information.

2. A memory system as claimed in claim 1, wherein said host domain includes stripe domains that are separated by a distance equal to their width to provide substantially zero net-magnetization.

3. A memory system as claimed in claim 1 or 2, including means for defining bit locations.

4. A memory system as claimed in any one of claims 1 to 3, including propagation means.

5. A method as claimed in claim 4, wherein said propagation means is a conductor pattern.

6. A memory system as claimed in claim 4, wherein said propagation means is a permalloy pattern.

7. A memory system as claimed in any one of the preceding claims, including confinement means to define a host domain pattern.

9

8.    A memory system as claimed in claim 7, wherein said confinement means includes etch grooves.

9.    A memory system as claimed in claim 7, wherein said confinement means includes ion-implanted regions.

10.    A memory system as claimed in any one of the preceding claims, wherein said host domain pattern contains at least one contiguous translation domain.

11.    A memory system as claimed in any of claims 1 to 9, wherein said host domain pattern contains at least one contiguous translation domain and at least one passive domain that is noncontiguous to the translation domain.

FIG. 1

FIG. 3

FIG. 2

FIG. 4

0042058

FIG. 5

## DOCUMENTS CONSIDERED TO BE RELEVANT

| Category | Citation of document with indication, where appropriate, of relevant passages | Relevant to claim |
|---|---|---|
| X | FR - A - 2 378 330 (PHILIPS GLOEI-LAMPENFABRIEKEN)  <br> * Page 12, line 29 - page 18, line 12; page 19, line 29 - page 20, line 22; page 25, line 1 - page 27, line 14; page 33, line 21 - page 37, line 17; figures 3,4,7,8,16-18,23,24 * | 1-7, 10,11 |
| A | IEEE TRANSACTIONS ON MAGNETICS, vol. 9, no. 3, September 1973, pages 517-520 New York, U.S.A. HIDEKI NISHIDA et al.: "Formation of normal and hard bubbles by cutting strip domains"  <br> * Complete article * | 1 |
| A | MAGNETISM AND MAGNETIC MATERIALS, 18th Annual conference Denver 1972, American Institute of Physics Conference Proceedings, no. 10, part I & II, 1973, pages 442-457 New York, U.S.A. W.J. TABOR et al.: "A new type of cylindrical magnetic domain (hard bubble)"  <br> * Page 444, line 4 - page 445, line 44; figures 2,3(A,B,C) * | 1 |

CLASSIFICATION OF THE APPLICATION (Int. Cl.³)

G 11 C 19/08

TECHNICAL FIELDS SEARCHED (Int. Cl.³)

G 11 C 19/08

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 28-09-1981 | DEGRAEVE |

EPO Form 1503.1  06.78